# EUROPÄISCHE PATENTANMELDUNG

(11) **EP 4 425 792 A1**
(43) Veröffentlichungstag der Anmeldung: **04.09.2024**
(21) Anmeldenummer: 24160358.8
(22) Anmeldetag: 28.02.2024
(51) Int. Cl.: H03K 17/18, H03K 17/955, H03K 17/96

(54) **ANZEIGEEINRICHTUNG MIT KAPAZITIVER NÄHERUNGSSENSORIK, ELEKTRISCHES GERÄT UND VERFAHREN ZUM BETREIBEN EINES SOLCHEN ELEKTRISCHEN GERÄTS**

(30) Priorität: 01.03.2023 DE 102023105022
(71) Anmelder: Turck Holding GmbH, 58553 Halver (DE)
(72) Erfinder: vom Stein, Johannes, 42499 Hückeswagen (DE)
(74) Vertreter: DTS Patent- und Rechtsanwälte PartmbB

(57) **Zusammenfassung**

Die vorliegende Erfindung betrifft eine Anzeigeeinrichtung (1) mit kapazitiver Näherungssensorik, umfassend eine Lichtquelle (4, 24) zum Erzeugen einer Lichtemission; einen Lichtleiterkörper (2, 22) mit einer Licht-Einkoppelfläche (14) zum Einkoppeln der Lichtemission und einer Licht-Auskoppelfläche (11) zum Auskoppeln der Lichtemission. Ferner umfasst die Anzeigeeinrichtung (1) eine Isolationsschicht (8, 28); eine elektrisch leitfähige Schicht (6 ,26), die zwischen der Licht-Auskoppelfläche und der Isolationsschicht angeordnet ist; eine Sensoreinheit (17, 27), die mit der elektrisch leitfähigen Schicht gekoppelt und dazu eingerichtet ist, eine kapazitive Näherungsdetektion durchzuführen und ein Schaltsignal auszugeben; und eine Steuereinheit (20), die mit der Sensoreinheit (17, 27) und der Lichtquelle (4, 24) gekoppelt und dazu eingerichtet ist, anhand eines Sensorsignals die Lichtemission der Lichtquelle (4, 24) zu steuern. Dabei ist die Isolationsschicht (8, 28) nach außen gewölbt. Die Erfindung betrifft ferner ein elektrische Gerät (31) und ein Verfahren zum Betreiben des elektrischen Geräts (31).

## Beschreibung

Die vorliegende Erfindung betrifft eine Anzeigeeinrichtung mit kapazitiver Näherungssensorik, ein elektrisches Gerät mit einer solchen Anzeigeeinrichtung und ein Verfahren zum Betreiben eines solchen elektrischen Geräts.

In vielen Kontexten werden Geräte verwendet, bei denen eine Aktivität oder ein Betriebszustand ständig mittels einer Anzeigefunktion ausgegeben wird. Dies kann beispielsweise durch ein Leuchtsignal erfolgen, über welches eine Funktion des Geräts oder auch eine Fehlfunktion angezeigt werden kann.

Ferner gibt es Bedienmöglichkeiten, auch im Zusammenhang mit Anzeigeeinrichtungen, um auf den Betriebszustand des Geräts Einfluss zu nehmen oder Eingaben zu ermöglichen.

Die DE 10 2017 103 706 zeigt einen Aufbau einer Elektrode für einem kapazitiven Näherungsschalter, der auf einer Leiterkarte in einem Gehäuse montiert werden kann. Dabei wird zum Betätigen eine Annäherung an eine markierte Gehäusefläche detektiert.

DE 20 2020 005 590 offenbart eine Kombination einer LED-Anzeige mit Lichtleiter und optischem Sensor.

DE 10 326 684 A1 offenbart eine Sensorvorrichtung zur Erzeugung eines Schaltsignals durch ein kapazitives Element auf einer durchsichtigen flächigen Blende.

DE 10 123 633 A1 offenbart eine Berührungsschalteranordnung mit einer Sensorfläche, die an der Unterseite einer Bedienoberfläche anliegt und zumindest teilweise lichtdurchlässig ist.

DE 10 2006 022 965 offenbart einer Bedieneinheit zum Einbau hinter einer Blende mit einem Lichtleiter, der das Licht umlenkt.

EP 1 446 879 B1 zeigt eine Anordnung eines Berührungsschalters mit flächigem Trägersubstrat, einem leitfähigem Elektrodenpad und einer separaten Dekoration.

Bei optischen Sensoren kann es dabei zu einer störenden Beeinflussung durch Fremdlicht und die Lichtquelle selbst kommen und der Sensor setzt gegebenenfalls voraus, dass die Lichtquelle leuchtet. Ferner kann es zu einer Abdunkelung kommen, etwa durch andere Gegenstände oder Flüssigkeiten wie beispielsweise Ölspritzer.

Es ist die Aufgabe der vorliegenden Erfindung, eine Anzeigeeinrichtung bereitzustellen, die zugleich eine einfache Bedienung ermöglicht.

Diese Aufgabe wird erfindungsgemäß gelöst durch eine Anzeigeeinrichtung, ein elektrisches Gerät und ein Verfahren zum Betreiben des elektrischen Geräts mit den Merkmalen der unabhängigen Ansprüche. Vorteilhafte Ausgestaltungen sind in den Unteransprüchen angegeben.

Danach wird die Aufgabe gelöst durch eine Anzeigeeinrichtung mit kapazitiver Näherungssensorik, die eine Lichtquelle zum Erzeugen einer Lichtemission und einen Lichtleiterkörper umfasst. Der Lichtleiterkörper weist eine Licht-Einkoppelfläche zum Einkoppeln der Lichtemission und eine Licht-Auskoppelfläche zum Auskoppeln der Lichtemission auf. Ferner sind eine Isolationsschicht und eine zwischen der Licht-Auskoppelfläche und der Isolationsschicht angeordnete elektrisch leitfähige Schicht sowie eine Sensoreinheit vorgesehen. Dabei ist die Sensoreinheit mit der elektrisch leitfähigen Schicht gekoppelt und dazu eingerichtet, eine kapazitive Näherungsdetektion durchzuführen und in Abhängigkeit von der Näherungsdetektion ein Schaltsignal auszugeben. Dabei ist die Isolationsschicht nach außen gewölbt. Insbesondere kann auch die Licht-Auskoppelfläche nach außen gewölbt sein.

Insbesondere sind dabei die Licht-Auskoppelfläche, die elektrisch leitfähige Schicht und die Isolationsschicht aneinander angrenzend angeordnet. Die elektrisch leitfähige Schicht kann in Form einer auf den Lichtleiterkörper aufgebrachten Schicht ausgebildet sein; ferner kann die Isolationsschicht in Form einer auf die elektrisch leitfähige Schicht und/oder auf den Lichtleiterkörper aufgebrachten Schicht ausgebildet sein.

Die Erfindung kombiniert eine einfach und intuitiv bedienbare Näherungssensorik mit einer Leuchtanzeige, deren Lichtemission möglichst unabhängig vom Betrachtungswinkel erfassbar ist.

Die Erfindung basiert ferner auf der Erkenntnis, dass bei dieser Ausbildung der Anzeigeeinrichtung mit einer nach außen gewölbten Licht-Auskoppelfläche und/oder Isolationsschicht ein ausgegebenes Lichtsignal besonders gut und von vielen Seiten erfasst werden kann. Ferner kann eine solche Fläche auch tastend von einem Nutzer gut erfasst beziehungsweise aufgefunden werden, selbst bei schwacher oder ohne Beleuchtung.

Ferner kann eine besonders gute und intuitive Bedienbarkeit erhalten werden, indem die Näherungssensorik im Bereich der Lichtauskopplung erfolgt. Ein Bediener braucht sich daher nur an den leuchtenden Bereich anzunähern, etwa mit seinem Finger oder einen Betätigungselement, um die Näherungsdetektion auszulösen.

Die elektrisch isolierende Isolationsschicht dient dabei dazu, einen direkten leitenden Kontakt zwischen einem Betätigungselement beziehungsweise einem Finger des Nutzers und der elektrisch leitfähigen Schicht der Anzeigeeinrichtung zu vermeiden. Auch bei einer direkten Berührung der Anzeigeeinrichtung, insbesondere im Bereich der Lichtauskopplung, erfolgt daher die Annäherung maximal bis zur Dicke der Isolationsschicht.

Die Lichtquelle kann dabei auf an sich bekannte Weise gebildet sein. Bei einer Ausbildung umfasst die Lichtquelle eine Leuchtdiode (LED), aber es sind auch andere Lichtquellen denkbar. Die Lichtquelle ist insbesondere so ausgebildet, dass durch eine Ansteuerung die Intensität, Farbe oder ein dynamischer Parameter wie periodische Intensitäts- und/oder Farbveränderung eingestellt werden können.

Bei einer Ausbildung kann die Lichtquelle auch mehrteilig ausgebildet sein. Sie kann beispielsweise auch eine Anzeige umfassen, mittels welcher eine grafische Darstellung mittels Bildpunkten oder mittels einer Segmentanzeige ausgegeben werden kann. In einer weiteren Ausbildung kann dies explizit ausgeschlossen sein und die Lichtquelle kann als einzelnes Element oder so ausgebildet sein, dass sie lediglich als Lichtunkt oder Leuchtfläche wahrnehmbar ist, oder wobei eine bedruckte Fläche hinterleuchtet werden kann.

Bei einer weiteren Ausbildung weist der Lichtleiterkörper eine Längsachse auf. Er kann um diese Längsachse rotationssymmetrisch ausgebildet sein, insbesondere zylindrisch oder kegelförmig. Der Lichtleiterkörper kann ferner so ausgebildet sein, dass er sich trichterförmig in Lichtstrahlrichtung, das heißt in eine Richtung von der Licht-Einkoppelfläche zur Licht-Auskoppelfläche, weitet.

Ferner kann der Lichtleiterkörper aus einem Kunststoffmaterial, insbesondere einem Polymer, gebildet sein. Zudem kann die Isolationsschicht aus dem gleichen Kunststoffmaterial, insbesondere einem Polymer, wie der Lichtleiterkörper gebildet sein.

Der Lichtleiterkörper kann aus einem solche Material beispielsweise mittels Spritzguss gefertigt werden. Weitere Elemente können dann etwa durch Umspritzen einteilig mit dem Lichtleiterkörper ausgebildet sein.

Der Lichtleiterkörper ist so gebildet, dass er ein Leiten einer Lichtemission von der Licht-Einkoppelfläche zu der Licht-Auskoppelfläche erlaubt. Insbesondere erfolgt dies dadurch, dass die eingekoppelte Lichtemission das durchsichtige Material durchdringt, ferner erfolgt beim Auftreffen des Lichts unter einem flachen Winkel auf die Grenzfläche zwischen dem Lichtleiterkörper und einem umgebenden Medium eine totale Reflexion.

Die Licht-Auskoppelfläche und/oder die Isolationsschicht ist auf eine solche Weise nach außen, das heißt insbesondere von der Licht-Einkoppelfläche weg gewölbt beziehungsweise konvex ausgebildet, dass eine ausgekoppelte Lichtemission in einem möglichst breiten Winkel abgestrahlt werden kann.

Dabei kann der Lichtleiterkörper so geformt sein, dass die Licht-Auskoppelfläche nach außen gewölbt ist.

Die Isolationsschicht ist insbesondere so nach außen gewölbt ausgebildet, dass die Anzeigeeinrichtung bei einem Einbau in ein elektrisches Gerät für einen Nutzer tastend erfassbar ist.

Bei einer Ausbildung kann vorgesehen sein, dass die Lichtemission aus dem Lichtleiterkörper bei einer flachen Licht-Auskoppelfläche ausgekoppelt wird und anschließend durch die nach außen gewölbte Isolationsschicht in einem größeren Abstrahlwinkel abgegeben wird. Hierzu kann die Isolationsschicht auch eine Streuschicht aufweisen, etwa einen aufgerauten Bereich oder eine Streufolie.

Es ist also insbesondere eine Ausbildung der Licht-Auskoppelschicht und der Isolationsschicht so vorgesehen, dass die Wölbung nach außen erhalten wird und dass die ausgekoppelte Lichtemission unter einem breiten Winkel abgegeben wird. Die Lichtemission ist daher für einen Nutzer aus verschiedenen Winkeln und insbesondere auch von der Seite her erkennbar.

Beispielsweise kann die Abstrahlung mit einem Abstrahlwinkel von zumindest 60° zur Längsachse des Lichtleiterkörpers, bevorzugt zumindest 75°, weiter bevorzugt zumindest 90° erfolgen.

Die nach außen gewölbte Licht-Auskoppelfläche und/oder Isolationsschicht kann rund ausgebildet sein. Sie kann ferner eine Spitze aufweisen, beispielsweise nach Art einer Kegelspitze oder einer abgerundeten Kegelspitze oder einer Spitze mit einer gewölbten Mantelfläche. Die Wölbung der Fläche nach außen kann ferner nach Art einer Konvexlinse gebildet sein, um eine bestimmte Abstrahlcharakteristik der Anzeigeeinrichtung zu gewährleisten.

Die kapazitive Näherungsdetektion erfolgt auf an sich bekannte Weise. Mittels der Sensoreinheit wird anhand der elektrisch leitfähigen Schicht ein kapazitiver Parameter bestimmt, der sich in Abhängigkeit von einer Annäherung eines Betätigungsobjekts, etwa eines Fingers eines Nutzers, verändert. Die so detektierte Annäherung wird ausgewertet und beispielsweise wird ein Abgleich mit einem Schwellenwert ausgeführt, wobei in Abhängigkeit von dem Abgleich das Schaltsignal erzeugt und ausgegeben wird.

Bei der Messung des kapazitiven Parameters kann ferner eine Referenzelektrode verwendet werden, wobei beispielsweise eine elektrisch leitfähige Schicht einer weiteren Anzeigeeinheit verwendet werden kann.

Bei einer Weiterbildung ist die elektrisch leitfähige Schicht im Bereich der Licht-Auskoppelfläche angeordnet und mit dieser fest verbunden. Die elektrisch leitfähige Schicht erstreckt sich dabei zumindest teilweise über einen für einen Nutzer von außen sichtbaren Bereich der Licht-Auskoppelfläche. Die elektrisch leitfähige Schicht muss daher in diesem Fall so transparent ausgebildet sein, dass die ausgekoppelte Lichtemission wenigstens teilweise durch sie hindurchtreten kann. Dies erfolgt insbesondere in einem Durchtrittsbereich der elektrisch leitfähigen Schicht.

Ferner kann die elektrisch leitfähige Schicht mittels Aufdampfen oder mittels eines benetzenden Verfahrens auf den Lichtleiterkörper aufgebracht sein. Beispielsweise können Verfahren wie die Kathodenzerstäubung (insbesondere "Sputtern") oder ein anderes Beschichtungsverfahren, insbesondere durch Nassauftrag eines Materials zur Bescheidung, vorgesehen sein. Die elektrisch leitfähige Schicht kann ferner mittels Bedrucken erhalten werden.

Es kann ferner ein Umspritzverfahren verwendet werden, um den Lichtleiterkörper und die elektrisch leitfähige Schicht zu verbinden, insbesondere durch Umspritzen mit einem Material, aus dem die Isolationsschicht gebildet wird.

Ferner kann die elektrisch leitfähige Schicht den Lichtleiterkörper zumindest teilweise umschließen. Die elektrisch leitfähige Schicht kann sich beispielweise ganz oder teilweise über die Mantelfläche eines rotationssymmetrischen Lichtleiterkörpers erstrecken; insbesondere ist die elektrisch leifähige Schicht dazu ausgebildet, die Lichtleitung im Lichtleiterkörper zu unterstützen, indem sie Licht im Lichtleiterkörper reflektiert. Auf diese Weise kann die elektrisch leitfähige Schicht im Bereich der Licht-Auskopplungsfläche aus der Richtung der Licht-Einkoppelfläche elektrisch kontaktiert werden, etwa zum Koppeln beziehungsweise zum elektrischen Verbinden der elektrisch leitfähigen Schicht mit der Sensoreinheit.

Ferner kann die elektrisch leifähige Schicht Indium-Zinn-Oxid (ITO) umfassen. Ferner kann beispielsweise Grafit verwendet werden.

Alternativ oder zusätzlich können andere geeignete Materialien verwendet werden, etwa ein leitfähiger Kunststoff oder in leitfähiges Polymer, elektrisch leitfähige Partikel wie Kohle- oder Grafit-Partikel oder Verbundstoffe.

Insbesondere ist die elektrisch leitfähige Schicht als dünne Schicht ausgebildet, etwa mit einer Dicke von 5 µm bis 100 µm.

Ferner können der Lichtleiterkörper, die elektrisch leitfähige Schicht und die Isolationsschicht zu einer Einheit verbunden sein. Insbesondere können der Lichtleiterkörper und die Isolationsschicht eine Einheit aus gleichem Material sein, in welches die elektrisch leitfähige Schicht eingeschlossen ist.

Ferner kann die elektrisch leitfähige Schicht, insbesondere im Bereich der Licht-Auskoppelfläche, ein transparentes, insbesondere dünnes, homogenes Material, etwa eine leitende Folie oder eine Metall-Beschichtung, oder ein inhomogenes Material, etwa ein feines Metallgitter, umfassen. Insbesondere kann die elektrisch leitfähige Schicht als dünne Schicht ausgebildet, etwa mit einer Dicke von 5 µm bis 100 µm. Die elektrisch leitfähige Schicht ist im Bereich der Licht-Auskoppelfläche so ausgebildet, dass eine ausgekoppelte Lichtemission zumindest teilweise hindurchtreten kann. Die elektrisch leitfähige Schicht sollte zumindest die Lichtemission nur zu einem bestimmten Grad reflektieren oder absorbieren.

Bei einer inhomogenen Materialverteilung, etwa bei einem Gitter oder einer Ringstruktur der elektrisch leitfähigen Schicht, können ausgesparte Bereiche sicherstellen, dass genügend Licht durchtreten kann.

Bei einer Ausbildung ist ein Volumen zwischen der Lichtquelle und der Licht-Einkoppelfläche mit Luft oder mit einem Füllmaterial gefüllt. Dadurch kann vorteilhafterweise eine verbesserte Stabilität der Anzeigeeinrichtung erhalten werden.

Beispielsweise kann eine Vergussmasse vorgesehen sein oder ein transparentes Kunststoffmaterial. Ein geeignetes Spritzgussverfahren kann bei der Fertigung verwendet werden, um die entsprechende Verfüllung zwischen der Lichtquelle und der Licht-Einkoppelfläche des Lichtleiterkörpers zu erhalten.

Bei einer weiteren Ausbildung ist eine Kontaktierung zum Koppeln der Sensoreinheit mit der elektrisch leitfähigen Schicht vorgesehen, welche ein federndes Metall-Material umfasst. Insbesondere erzeugt das federnde Metall-Material über eine Rückstellkraft einen Anpressdruck auf eine Kontaktierungsfläche der elektrisch leitfähigen Schicht.

Die Kontaktierung kann ferner so ausgelegt sein, dass sie den Lichtleiterkörper ringsum umschließt. Es kann auch eine Elektrode vorgesehen sein, bei der ein Schaumstoffkörper von einer Metallfolie umgeben ist, um eine sichere Kontaktierung zu erhalten.

Das elektrische Gerät, insbesondere ein Feldbusmodul, weist ein Gehäuse und zumindest eine Anzeigeeinrichtung gemäß dieser Beschreibung auf. Dabei ist der Lichtleiterkörper der Anzeigeeinrichtung so angeordnet, dass die nach außen gewölbte Isolationsschicht einen Vorsprung des Gehäuses bildet. Dieser Vorsprung ist insbesondere für einen Nutzer tastbar beziehungsweise taktil erfassbar ausgebildet.

Ein Feldbusmodul kann beispielsweise ein elektrisches Gerät sein, welches über einen Feldbus in ein datentechnisches Netzwerk eingebunden ist. Beispiele solcher Feldbusmodule umfassen Feldgeräte wie Aktoren und Sensoren, Switches, Leistungsversorgungsmodule, Module zur Übertragung von Daten zwischen Feldgeräten und einem Netzwerk, Steuergeräte oder andere.

Bei einer Ausbildung wird die Isolationsschicht durch einen Abschnitt des Gehäuses des elektrischen Geräts gebildet. Die Isolationsschicht kann beispielsweise von einem aus einem Kunststoff gebildeten Abschnitt des Gehäuses oder einem einteilig mit diesem ausgebildeten Abschnitt gebildet werden. Dieser Abschnitt ist insbesondere transparent gebildet. Bei einer solchen Ausbildung ist der Abschnitt, der die Isolationsschicht bildet, nach außen gewölbt ausgebildet, insbesondere so dass er tastend erfassbar ist.

Alternativ kann das Gehäuse des elektrischen Geräts eine Ausnehmung aufweisen, durch welche die nach außen gewölbte Isolationsschicht der im Gehäuseinneren angeordneten Anzeigeeinrichtung nach außen ragen kann, insbesondere so dass sie tastend als konvexe Wölbung erfassbar ist.

Das Gehäuse kann auf einer Außen- und/oder Innenseite bedruckt, beschichtet oder beklebt sein, um Lichtaustritt an anderen Stellen als den dafür vorgesehenen zu verhindern. Die Isolationsschicht kann auch aus einer Folie oder einer dünnen Schicht bestehen, die zum Beispiel das ganze Gehäuse oder einen Abschnitt davon bedeckt.

Bei einer weiteren Ausbildung ist die Sensoreinheit dazu eingerichtet, eine Annäherung an die erste elektrisch leitfähige Schicht einer ersten Anzeigeeinrichtung anhand einer Referenzmessung für eine zweite elektrisch leitfähige Schicht einer zweiten Anzeigeeinrichtung zu erfassen. Insbesondere ist die zweite Anzeigeeinrichtung analog zu der ersten Anzeigeeinrichtung aufgebaut. Es kann vorgesehen sein, dass die Sensoreinheit der ersten Anzeigeeinrichtung mit der elektrisch leitfähigen Schicht der zweiten Anzeigeeinrichtung gekoppelt ist.

Dies vereinfacht die Erfassung insofern, als durch einen Vergleich der Signale an sich analog zueinander aufgebauter Anzeigeeinrichtungen eine besonders einfache Auswertung vorgenommen werden kann; insbesondere kann so auch einfach bestimmt werden, an welche der Anzeigeeinrichtungen eine stärkere Annäherung als an die andere erfolgt.

Bei dem Verfahren zum Betreiben eines elektrischen Geräts mit einer Anzeigeeinrichtung gemäß dieser Beschreibung wird ein Dunkel-Anzeigemodus des elektrischen Geräts aktiviert. Es wird eine Betätigung der kapazitiven Näherungssensorik der Anzeigeeinrichtung erfasst und ein Hell-Anzeigemodus des elektrischen Geräts wird aktiviert.

Zum Beispiel kann das elektrische Gerät eine Mehrzahl von Leuchtanzeigen neben der Anzeigeeinrichtung umfassen.

Der Dunkel-Anzeigemodus kann beispielsweise aktiviert werden, nachdem ein bestimmtes Zeitintervall nach einer zuletzt erfassten Bedienung des elektrischen Geräts abgelaufen ist. Der Dunkel-Betriebsmodus kann ferner durch eine Benutzereingabe oder ein Dunkel-Aktivierungssignal aktiviert werden.

Ein Dunkel-Anzeigemodus des elektrischen Geräts kann dann so ausgebildet sein, dass dabei weniger oder keine Leuchtanzeigen außer der Anzeigeeinrichtung aktiviert sind und somit im Dunkel-Anzeigemodus weniger oder keine Energie zur Ausgabe von Lichtsignalen mittels der weiteren Leuchtanzeigen benötigt wird. Ferner kann vorgesehen sein, dass im Dunkel-Anzeigemodus die Ausgabe von Lichtsignalen mittels der weiteren Leuchtanzeigen mit geringerer Intensität erfolgt und/oder dass in einem reduzierten Umfang nur eine Teilmenge der sonst ausgebbaren Leuchtsignale ausgegeben wird. Beispielsweise kann die Ausgabe auf Fehlermeldungen oder Notfall-Signale beschränkt sein.

Im Dunkel-Anzeigemodus kann zudem vorgesehen sein, dass nur noch die Anzeigeeinrichtung mit der Näherungssensorik beleuchtet wird. Wird nun eine Annäherung detektiert und von der Sensoreinheit ein Schaltsignal ausgegeben, so wird der Hell-Anzeigemodus des elektrischen Geräts aktiviert.

Im Hell-Anzeigemodus sind - im Gegensatz zum Dunkel-Anzeigemodus - die vollen Ausgabefunktionen der weiteren Leuchtanzeigen aktiviert.

Nach der Aktivierung des Hell-Anzeigemodus anhand einer Betätigung der Näherungsdetektion kann vorgesehen sein, dass nach Ablauf eines bestimmten Zeitintervalls (Time-Out) ohne weitere Bedienung wieder der Dunkel-Anzeigemodus aktiviert wird.

Insbesondere ist die Anzeigeeinrichtung mit der Näherungssensorik als kombinierte Anzeige und Schalter für den Dunkel-Anzeigemodus vorgesehen. Beispielsweise kann diese Zuordnung mittels einer Beschriftung ausgeführt sein.

Das heißt, mittels der Anzeigeeinrichtung kann eine Zuschaltung der Leuchtanzeige bei Feldbusmodulen durch Berührung einer Leuchtanzeige ermöglicht werden, die etwa einen Status "Anzeige-Energiesparmodus" oder einen anderen Hinweis auf den aktiven Dunkel-Anzeigemodus anzeigt. Dabei wird vorteilhafterweise die zur Anzeige des Dunkel-Anzeigemodus verwendete Leuchtanzeige mit ihrem Lichtleiter auch zur Ermittlung der Berührung durch Näherungsdetektion genutzt.

Weitere Einzelheiten und Vorteile der Erfindung sollen nun anhand eines in den Zeichnungen dargestellten Ausführungsbeispiels näher erläutert werden.

Es zeigen:
- Fig. 1: eine schematische Darstellung der Anzeigeeinheit;
- Fig. 2: eine schematische Darstellung zweier benachbart zueinander angeordneter Anzeigeeinheiten; und
- Fig. 3: eine schematische Darstellung eines elektrischen Geräts.

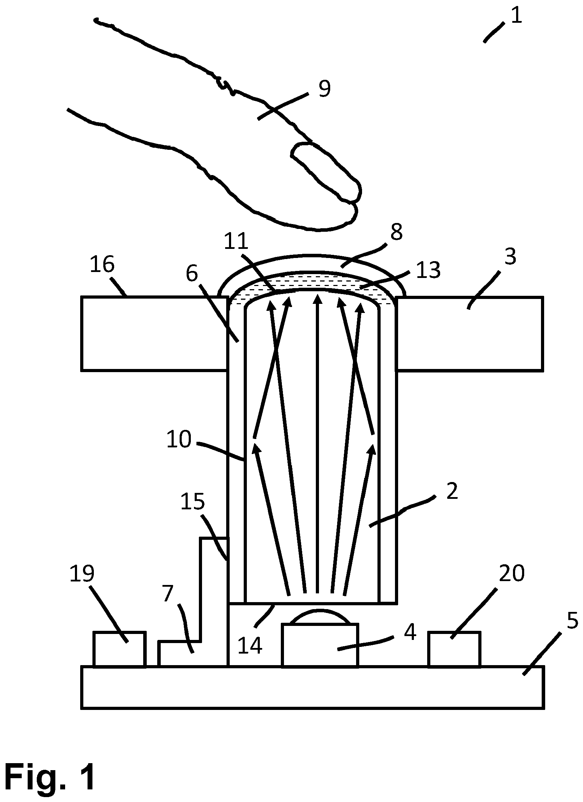

Mit Bezug zu Fig. 1 wird eine schematische Darstellung der Anzeigeeinheit erläutert.

Die Anzeigeeinrichtung 1 umfasst einen Lichtleiterkörper 2.

Der Lichtleiterkörper 2 ist bei diesem Beispiel zylinderförmig ausgebildet.

Er weist an seinem in Fig. 1 unten gezeigten Ende eine Licht-Einkoppelfläche 14 auf.

Die Licht-Einkoppelfläche 14 ist bei dem Beispiel flach ausgebildet. Bei weiteren Ausführungsbeispielen kann eine konkave Form der Licht-Einkoppelfläche vorgesehen sein, insbesondere um die Einkoppelung einer Lichtemission zu optimieren.

Zum Erzeugen einer in den Lichtleiterkörper 2 einkoppelbaren Lichtemission ist eine Lichtquelle 4 in Fig. 1 unterhalb der Licht-Einkoppelfläche 14 angeordnet.

Die Lichtquelle 4 ist bei dem Beispiel als LED 4 ausgebildet. Bei weiteren Ausführungsbeispielen können alternativ oder zusätzlich andere Lichtquellentypen vorgesehen sein.

Die Lichtquelle 4 ist so ausgebildet und angeordnet, dass sie eine Lichtemission erzeugt und so abstrahlt, dass diese wenigstens teilweise durch die Licht-Einkoppelfläche 14 in den Lichtleiterkörper 2 eingekoppelt wird.

Bei dem Beispiel ist die Lichtquelle 4 auf einer Platine 5 beziehungsweise auf einer Leiterkarte angeordnet, über welche eine elektrische Energieversorgung erfolgt.

Die Leitung einer eingekoppelten Lichtemission im Lichtleiterkörper 2 erfolgt auf an sich bekannte Weise mittels Totalreflexion an einer Grenzfläche 10 des Materials des Lichtleiterkörpers 2

Unterstützend kann ferner eine reflektierende Schicht auf der seitlichen Mantelfläche des Lichtleiterkörpers 2 angeordnet sein, um sicherzustellen, dass auch durch die Grenzfläche 10 hindurchtretendes Licht reflektiert und weiter im Lichtleiterkörper 2 geleitet wird. Die Rolle dieser reflektierenden Schicht kann etwa die nachfolgend näher erläuterte elektrisch leitfähige Schicht 6 erfüllen.

Am entgegengesetzten Ende des Lichtleiterkörpers 2 ist eine Licht-Auskoppelfläche 11 angeordnet.

Diese ist bei dem Beispiel nach außen gewölbt mit einer konvexen Rundung ausgebildet.

Bei weiteren Ausführungsbeispielen kann die Licht-Auskoppelfläche 11 eine andere geometrische Form aufweisen, etwa eine Kegelform, beispielsweise mit einer abgerundeten Mantelfläche.

Bei weiteren Ausführungsbeispielen kann die Licht-Auskoppelfläche 11 ferner eine Strukturierung aufweisen, insbesondere um die Auskoppelung einer Lichtemission zu optimieren.

Die Licht-Auskoppelfläche 11 ist insbesondere so gebildet, dass eine durch den Lichtleiterkörper 2 geleitete Lichtemission mit einer räumlichen Verteilung ausgekoppelt wird, die einen Öffnungswinkel von 180° aufweist. Bei weiteren Ausführungsbeispielen kann der Öffnungswinkel der ausgegebenen Lichtemission zumindest 120° betragen, bevorzugt zumindest 150°.

Eine elektrisch leitfähige Schicht 6 ist im Bereich der Licht-Auskoppelfläche 11 angeordnet.

Bei dem Beispiel ist diese als auf den Lichtleiterkörper aufgebrachte Schicht aus einem zumindest teilweise transparenten elektrisch leitfähigen Material ausgebildet, beispielsweise aus Indium-Zinn-Oxid (ITO) oder aus einem leitfähigen Polymer. Insbesondere ist dabei eine im Wesentlichen homogene, gleichmäßig dünne Schicht auf der Licht-Auskoppelfläche 11 ausgebildet.

Bei dem Beispiel erstreckt sich die elektrisch leitfähige Schicht 6 über die gesamte nach außen gewölbte Oberfläche der Licht-Auskoppelfläche. In Fig. 1 ist dieser Bereich als Durchtrittsbereich 13 dargestellt.

Bei weiteren Ausführungsbeispiele kann die elektrisch leitfähige Schicht 6 im Durchtrittsbereich 13 als Netz oder Gitter aus einem weniger oder nicht transparenten Material ausgebildet sein, etwa aus einem metallischen Material.

Bei weiteren Ausführungsbeispielen kann ferner vorgesehen sein, dass sich die elektrisch leitfähige Schicht 6 nicht über die gesamte Fläche der Licht-Auskoppelfläche 11 erstreckt, sondern über einen Teilbereich, insbesondere einen Randbereich.

Beispielsweise kann die elektrisch leitfähige Schicht 6 entlang des gesamten Randes der Licht-Auskoppelfläche 11 umlaufend angeordnet sein, sodass in der Mitte ein nicht durch die elektrisch leitfähige Schicht 6 bedeckter Bereich ausgebildet ist. In diesem Fall kann eine nicht lichtdurchlässige elektrisch leitfähige Schicht 6 die ausgekoppelte Lichtemission maskieren, sodass nur im mittigen Bereich Licht ausgekoppelt wird.

Ferner umfasst die Anzeigeeinrichtung 1 eine Isolationsschicht 8, die in Fig. 1 oberhalb der elektrisch leitfähigen Schicht 6 ausgebildet ist. Die geometrische Form der Isolationsschicht 8 folgt dabei dem Verlauf der Licht-Auskoppelfläche 11, sie ist also im gezeigten Fall konvex nach außen gewölbt.

Bei dem in Fig. 1 gezeigten Beispiel sind der Lichtleiterkörper 2, die elektrisch leitende Schicht 6 und die Isolationsschicht 8 so ausgebildet, dass sie bei dem Durchtrittsbereich 13 direkt aneinander anliegen.

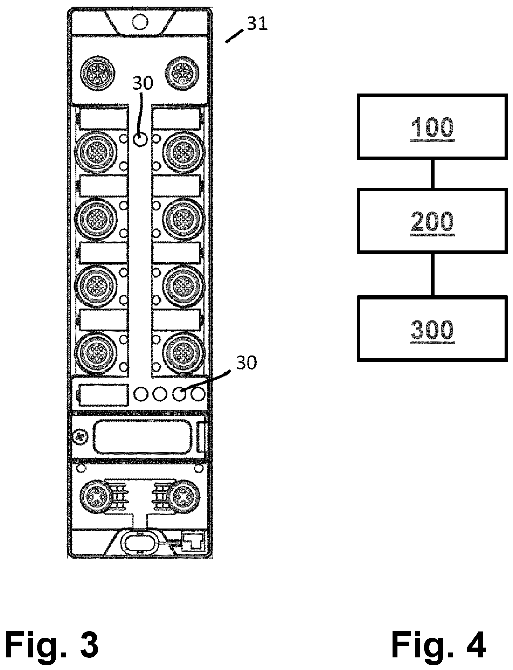

Bei dem Beispiel liegt die Isolationsschicht 8 an ihrem Rand an einer Gehäuseoberfläche 16 eines Gehäuses 3 an, welches beispielsweise zu einem elektrischen Gerät 31 gehört, welches unten mit Bezug zu Fig. 3 näher erläutert wird. In dem Gehäuse 3 ist hier eine Ausnehmung ausgebildet, in welche die Anzeigeeinrichtung 1 so eingesetzt wird, dass die nach außen gewölbte Isolationsschicht 8 als Vorsprung hervorragt.

Die Isolationsschicht 8 ist daher taktil erfassbar, wenn etwa ein Finger 9 über die Oberfläche 16 des Gehäuses 3 streicht.

Bei dem Beispiel ist ferner die elektrisch leitfähige Schicht 6 auch auf der seitlichen Mantelfläche des Lichtleiterkörpers 2 ausgebildet, sodass eine elektrische Kontaktierung bei einer Kontaktierungsfläche 15 gebildet werden kann.

Zum Zweck der Kontaktierbarkeit können auch auf andere Weise leitende Verbindungen von der im Austrittsbereich 13 ausgebildeten elektrisch leitfähigen Schicht 6 zur Kontaktierungsfläche 15 ausgebildet sein.

Zur Kontaktierung ist bei dem Beispiel der Fig. 1 ein Kontaktierungselement 7 vorgesehen. Dieses kann beispielsweise aus einem metallischen Material ausgebildet sein.

Es kann ferner ein Federelement vorgesehen sein, welches für einen Anpressdruck des Kontaktierungselements 7 an die Kontaktierungsfläche 15 sorgt. Der elektrische Kontakt wird dadurch sichergestellt.

Das Kontaktierungselement 7 ist auf der Platine 5 aufgebracht und mit dort ausgebildeten Leiterbahnen verbunden.

Über die Leiterbahnen ist eine Sensoreinheit 19 mit der elektrisch leitfähigen Schicht 6 elektrisch leitend verbunden. Bei diesem Beispiel ist die Sensoreinheit 19 ebenfalls auf der Platine 5 angeordnet.

Die Sensoreinheit 19 ist dazu ausgebildet, einen kapazitiven Parameter der elektrisch leitfähigen Schicht 6 zu messen, und Änderungen dieses Parameters zu detektieren. Anhand dieser Messung wird eine Näherungsdetektion ausgeführt.

Beispielsweise werden bei dem in Fig. 1 gezeigten Fall die kapazitiven Eigenschaften der elektrisch leitfähigen Schicht 6 durch einen angenäherten Finger 9 oder ein anderes Betätigungsobjekt verändert. Wenn mittels der Sensoreinheit 19 eine solche Annäherung detektiert wird und beispielsweise ein durch die Sensoreinheit 19 bestimmter Wert einen Schwellenwert über- oder unterschreitet, wird ein Schaltsignal ausgegeben.

Bei dem Beispiel der Fig. 1 ist ferner eine Steuereinheit 20 vorgesehen, die ebenfalls auf der Platine 5 angeordnet und mit der Sensoreinheit 19 verbunden ist. Die Steuereinheit 20 ist dazu eingerichtet, das von der Sensoreinheit 19 erzeugte Schaltsignal zu empfangen und beispielsweise eine Hell-Anzeigemodus zu aktiveren.

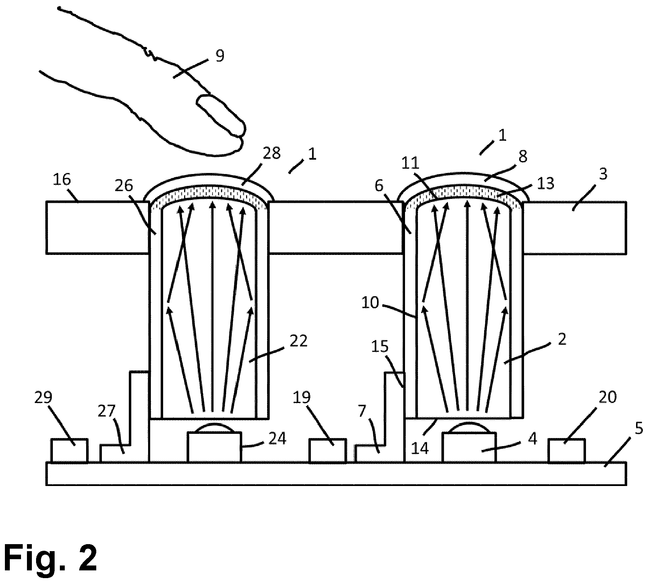

Mit Bezug zu Fig. 2 wird eine schematische Darstellung zweier benachbart zueinander angeordneter Anzeigeeinheiten erläutert. Dabei wird von den Erläuterungen zu dem in Fig. 1 gezeigten Ausführungsbeispiel ausgegangen.

Die in Fig. 2 gezeigten Anzeigeeinheiten 1 sind im Wesentlichen gleich aufgebaut wie die in Fig. 1 gezeigte Anzeigeeinheit 1.

Sie umfassen je einen Lichtleiterkörper 2, 22, der eine Licht-Einkoppelfläche 14 und eine konvex nach außen gewölbte Licht-Auskoppelfläche 11 aufweist.

Unterhalb des Lichtleiterkörpers 2, 22 im Bereich der Licht-Einkoppelfläche 14 ist jeweils eine Lichtquelle 4, 24 angeordnet.

Die beiden Lichtquellen 4, 24 sind auf einer Platine 5 angeordnet.

Ferner weisen die Lichtleiterkörper 2, 22 jeweils eine elektrisch leitfähige Schicht 6, 26 auf, die sich auch über den jeweiligen Durchtrittsbereich 13 bei der Licht-Auskoppelfläche 11 erstreckt.

Oberhalb der Licht-Auskoppelfläche 11 und der elektrisch leitfähigen Schicht 6, 26 ist jeweils eine Isolationsschicht 8, 28 angeordnet.

Die Isolationsschichten 8, 28 liegen jeweils am Rand an einer Gehäuseoberfläche 16 eines Gehäuses 3 auf. Das heißt, die Anzeigeeinrichtungen 1 sind bei dem Beispiel der Fig. 2 in Ausnehmungen des Gehäuses 3 so eingesetzt, dass die Isolationsschichten 8, 28 als Vorsprünge auf der Gehäuseoberfläche 16 tastbar sind.

Auf der Platine 5 ist ferner für jede Anzeigeeinrichtung 1 ein Kontaktierungselement 7, 27 vorgesehen. Dieses wird mittels eines federnden Abschnitts oder Elements bei einer Kontaktierungsfläche 15 an die Oberfläche des jeweiligen Lichtleiterkörpers 2, 22 angedrückt.

Von der Kontaktierungsfläche 15 aus verläuft eine elektrische Verbindung zu der im Bereich der Licht-Auskoppelfläche 11 angeordneten elektrisch leitfähigen Schicht 6, 26.

Im besonderen Fall des in Fig. 2 gezeigten Ausführungsbeispiels erstreckt sich die elektrisch leitfähige Schicht 6, 26 über die gesamte seitlichen Mantelfläche des in diesem Beispiel rotationssymmetrisch ausgebildeten Lichtleiterkörpers 2, 22. Die Kontaktierung ist dann besonders einfach, da die Kontaktierungsfläche 15 praktisch überall an der Mantelfläche angeordnet sein kann.

Ähnlich wie bei dem in Fig. 1 gezeigten Fall ist auch in Fig. 2 eine Sensoreinheit 19, 29 auf der Platine 5 angeordnet. Diese ist jeweils über Leiterbahnen der Platine 5 und über das Kontaktierungselement 7, 27 mit der elektrisch leitfähigen Schicht 6, 26 je einer Anzeigeeinrichtung 1 gekoppelt.

Es kann ferner vorgesehen sein, dass nur eine Sensoreinheit 19 vorgesehen ist, die mit beiden elektrisch leitfähigen Schichten 6, 26 gekoppelt ist. Hier kann zudem eine Annäherungsdetektion besonders einfach dadurch durchgeführt werden, dass kapazitive Parameter beider Anzeigeeinrichtungen 1 ausgewertet und verglichen werden.

Mit Bezug zu Fig. 3 wird ferner eine schematische Darstellung eines elektrischen Geräts 31 erläutert.

Das elektrische Gerät 31 kann insbesondere als Feldbusmodul 31 ausgebildet sein.

Das elektrische Gerät 31 umfasst eine Mehrzahl von Leuchtflächen 30. Zumindest eine davon ist als Anzeigeeinrichtung 1 gemäß der vorliegenden Beschreibung ausgebildet.

Mit Bezug zu Fig. 4 wird ferner ein Ausführungsbeispiel des Verfahrens erläutert.

Bei einem Schritt 100 wird ein Dunkel-Anzeigemodus des elektrischen Geräts 31 aktiviert. In dem Dunkel-Anzeigemodus sind die Leuchtflächen 30 bis auf eine deaktiviert und es ist lediglich noch eine der Leuchtflächen 30 aktiv, welche als Anzeigeeinheit 1 mit einer Näherungssensorik entsprechend dieser Beschreibung ausgebildet ist.

Bei dem Ausführungsbeispiel leuchtet diese Anzeigeeinheit 1 noch im Dunkel-Anzeigemodus, während die weiteren Leuchtfläche 30 des Geräts 31 nicht leuchten.

Durch die nach außen gewölbte Isolationsschicht 8, 28 und gegebenenfalls ebenfalls nach außen gewölbte Licht-Auskoppelschicht 6, 26 ist die aus dem Lichtleiterkörper 2, 22 ausgekoppelte Lichtemission unter vielen Winkeln zu erkennen, insbesondere auch wenn das Gerät 31 von der Seite her betrachtet wird.

Die Isolationsschicht kann ferner mittels des Tastsinns lokalisiert werden.

Bei dem Beispiel ist vorgesehen, dass der Dunkel-Anzeigemodus aktiviert wird, wenn mehr als ein vorgegebenes Zeitintervall keine Bedienung des Geräts 31 erfolgt ist.

In einem Schritt 200 wird eine Betätigung der Näherungssensorik der Anzeigeeinrichtung 1 erfasst, beispielsweise durch eine Berührung im Bereich der Isolationsschicht 8, 28 beziehungsweise bei einer Annäherung an die elektrisch leitfähige Schicht 6, 26 unter einen bestimmten Schwellenwert.

Die Sensoreinheit 19, 29 gibt daraufhin ein Schaltsignal aus, das von der Steuereinheit 20 ausgewertet wird.

In einem Schritt 300 wird ein Hell-Anzeigemodus des elektrischen Geräts 31 aktiviert. In diesem Modus sind die weiteren Leuchtflächen 30 des Geräts 31 aktiviert und sie geben durch Leuchtsignale beispielsweise Eingangs- und Ausgangszustände oder einen Betriebsstatus des Geräts 31 aus.

Eine Anwendung der Erfindung kann in einem Bereich erfolgen, wo Ein- und Ausgangszustände und Betriebsstatus etwa bei einem Feldbusmodul 31 erfolgt. Dies wird häufig mittels LEDs 30 ausgeführt. In einem Energiesparmodus (Dunkel-Anzeigemodus) können die LEDs 30 ausgeschaltet oder abgedunkelt werden, während über eine weitere, etwa über eine einzige andersfarbige LED 30, der den aktiven Energiesparmodus anzeigt.

In diesem Zustand sind dann allerdings die Betriebszustände nicht mehr sichtbar erkennbar. Die Anzeigeeinrichtung der vorliegenden Beschreibung erlaubt es nur beispielsweise, durch Berührung der Anzeigeeinrichtung 1 die LED-Anzeige durch die weiteren Leuchtflächen 30 wieder zu aktivieren (Leucht-Anzeigemodus), beispielsweise für eine begrenzte Zeit bis zum Time-Out oder bis zur nächsten Ab- und Zuschaltung der Spannungsversorgung.

Die Anzeigeeinrichtung 1 ist daher so eingerichtet, dass eine Annäherung oder Berührung des Moduls detektiert werden kann. Als intuitives Handling wird vorgesehen, dass die Berührung im Bereich der Licht-Auskoppelfläche 11 detektiert wird, wo auch im Dunkel-Anzeigemodus Licht emittiert wird.

Als Sensor wird ein kapazitiver Näherungsschalter vorgeschlagen, der im Gehäuse 3 angeordnet und in der Anzeigeeinrichtung 1 integriert ist.

Dabei ist die Isolationsschicht 8, 28 als kapazitiv wirkender Bereich und insbesondere auch die Licht-Auskoppelfläche 11 nach außen gewölbt ausgeführt, sodass die ausgekoppelte Lichtemission seitlich gut sichtbar ist, während die Anzeigeeinrichtung 1 mit dem Finger 9 ertastbar ist.

Ferner wird dabei erreicht, dass die von der Anzeigeeinrichtung (1) abgegebene Lichtemission in einem über die Gehäuseoberfläche (16) hinausragenden Bereich abgegeben wird und so seitlich gut sichtbar ist.

### Bezugszeichenliste

- 1: Anzeigeeinrichtung
- 2, 22: Lichtleiterkörper
- 3: Gehäuse
- 4, 24: Lichtquelle; LED
- 5: Platine
- 6, 26: Elektrisch leitfähige Schicht
- 7, 27: Kontaktierungselement
- 8, 28: Isolationsschicht
- 9: Finger
- 10: Grenzfläche
- 11: Licht-Auskoppelfläche
- 13: Durchtrittsbereich
- 14: Licht-Einkoppelfläche
- 15: Kontaktierungsfläche
- 16: Gehäuseoberfläche
- 19, 29: Sensoreinheit
- 20: Steuereinheit
- 30: Leuchtflächen
- 31: Elektrisches Gerät; Feldbusmodul

## Patentansprüche

1. Anzeigeeinrichtung (1) mit kapazitiver Näherungssensorik; umfassend
- eine Lichtquelle (4, 24) zum Erzeugen einer Lichtemission;
- einen Lichtleiterkörper (2, 22); mit
o einer Licht-Einkoppelfläche (14) zum Einkoppeln der Lichtemission; und
o einer Licht-Auskoppelfläche (11) zum Auskoppeln der Lichtemission;
- eine Isolationsschicht (8, 28);
- eine elektrisch leitfähige Schicht (6 ,26), die zwischen der Licht-Auskoppelfläche und der Isolationsschicht angeordnet ist;
- eine Sensoreinheit (17, 27), die mit der elektrisch leitfähigen Schicht gekoppelt und dazu eingerichtet ist, eine kapazitive Näherungsdetektion durchzuführen und ein Schaltsignal auszugeben; und
- eine Steuereinheit (20), die mit der Sensoreinheit (17, 27) und der Lichtquelle (4, 24) gekoppelt und dazu eingerichtet ist, anhand eines Sensorsignals die Lichtemission der Lichtquelle (4, 24) zu steuern;
- wobei die Isolationsschicht (8, 28) nach außen gewölbt ist.

2. Anzeigeeinrichtung gemäß Anspruch 1,
**dadurch gekennzeichnet, dass**
die Lichtquelle (4, 24) eine Leuchtdiode, LED, umfasst.

3. Anzeigeeinrichtung gemäß einem der vorhergehenden Ansprüche,
**dadurch gekennzeichnet, dass**
- der Lichtleiterkörper (2, 22) entlang einer Längsachse rotationssymmetrisch, insbesondere zylindrisch oder kegelförmig, ausgebildet ist; und/oder
- der Lichtleiterkörper (2, 22) aus einem Kunststoffmaterial gebildet ist.

4. Anzeigeeinrichtung gemäß einem der vorhergehenden Ansprüche,
**dadurch gekennzeichnet, dass**
- die elektrisch leitfähige Schicht (6 ,26) im Bereich der Licht-Auskoppelfläche (11) angeordnet und mit dieser fest verbunden ist; und/oder
- die elektrisch leitfähige Schicht (6, 26) mittels Aufdampfen oder mittels eines benetzenden Verfahrens auf den Lichtleiterkörper aufgebracht ist; und/oder
- die elektrisch leitfähige Schicht (6, 26) den Lichtleiterkörper (2, 22) zumindest teilweise umschließt; und/oder
- die elektrisch leitfähige Schicht Indium-Zinn-Oxid, ITO, umfasst; und/oder
- die elektrisch leitfähige Schicht (6, 26) ein transparentes, insbesondere dünnes, homogenes Material, etwa eine leitende Folie oder eine Metall-Beschichtung, oder ein inhomogenes Material, etwa ein feines Metallgitter, umfasst.

5. Anzeigeeinrichtung gemäß einem der vorhergehenden Ansprüche,
**dadurch gekennzeichnet, dass**
ein Volumen zwischen der Lichtquelle (14) und der Licht-Einkoppelfläche mit Luft oder mit einem Füllmaterial gefüllt ist.

6. Anzeigeeinrichtung gemäß einem der vorhergehenden Ansprüche,
**dadurch gekennzeichnet, dass**
eine Kontaktierung (7) zum Koppeln der Sensoreinheit (17, 27) mit der elektrisch leitfähigen Schicht (6, 26) vorgesehen ist, welche ein federndes Metall-Material umfasst.

7. Elektrisches Gerät (31), insbesondere Feldbusmodul (31), mit einem Gehäuse (3) und zumindest einer Anzeigeeinrichtung (1) nach einem der vorhergehenden Ansprüche, wobei der Lichtleiterkörper (2, 22) der Anzeigeeinrichtung (1) so angeordnet ist, dass die nach außen gewölbte Isolationsschicht (8, 28) einen Vorsprung des Gehäuses bildet.

8. Elektrisches Gerät (31) gemäß Anspruch 7,
**dadurch gekennzeichnet, dass**
die Isolationsschicht (8) durch einen Abschnitt des Gehäuses (3) gebildet wird.

9. Elektrisches Gerät (31) gemäß Anspruch 7 oder 8,
**dadurch gekennzeichnet, dass**
die Sensoreinheit (19, 29) dazu eingerichtet ist, eine Annäherung an die erste elektrisch leitfähige Schicht (6) einer ersten Anzeigeeinrichtung (1) anhand einer Referenzmessung für eine zweite elektrisch leitfähige Schicht (26) einer zweiten Anzeigeeinrichtung zu erfassen.

10. Verfahren zum Betreiben eines elektrischen Geräts (31) mit einer Anzeigeeinrichtung (1) nach einem der Ansprüche 1 bis 6, wobei
- ein Dunkel-Anzeigemodus des elektrischen Geräts (31) aktiviert wird;
- eine Betätigung der kapazitiven Näherungssensorik der Anzeigeeinrichtung (1) erfasst wird; und
- ein Hell-Anzeigemodus des elektrischen Geräts (31) aktiviert wird.
